# EUROPÄISCHE PATENTANMELDUNG

(11) **EP 2 354 107 A1**
(43) Veröffentlichungstag der Anmeldung: **10.08.2011**
(21) Anmeldenummer: 10153198.6
(22) Anmeldetag: 10.02.2010
(51) Int. Cl.: C03C 17/34

(54) **Verfahren zur Herstellung einer strukturierten TCO-Schutzschicht**

(71) Anmelder: Saint-Gobain Glass France, 92400 Courbevoie (FR)
(72) Erfinder: Ruitenberg, Gerard, Dr., 52072 Aachen (DE); Peter, Emmanuelle, 75012 Paris (FR); Metzger, Rudi, 52477 Alsdorf (DE); Gierens, Anne, 52064 Aachen (DE)
(74) Vertreter: Lendvai, Tomas

(57) **Zusammenfassung**

Verfahren zur Herstellung eines beschichteten Substrats, wobei
a. eine TCO-Schicht (2) mit einer Schichtdicke von 100 nm bis 1000 nm auf einem Substrat (1) abgeschieden wird,
b. eine inerte Deckschicht (3) mit einer mittleren Schichtdicke von 0,5 nm bis 5 nm auf der TCO-Schicht (2) abgeschieden wird und
c. das Substrat (1) bei 550 °C bis 800 °C geheizt und anschließend in einer Säure geätzt wird, wobei die inerte Deckschicht vor dem Ätzen nicht entfernt wird.
Das Substrat ist vorzugsweise Glas. Die Schichtabfolge ist zum Beispiel Glas / Si₃N₄ / AZO / Si₃N₄ (AZO = Aluminium-dotiertes Zinkoxid).

## Beschreibung

Die Erfindung betrifft ein Verfahren zur Herstellung einer strukturierten TCO - Schutzschicht, ein Substrat mit strukturierter TCO - Schutzschicht und deren Verwendung in Solarzellen und/oder Displays.

Mit optisch transparenten, elektrisch leitfähigen Beschichtungen wie TCOs (Transparent Conductive Oxides) versehene Substrate werden in vielen Bereichen der Photovoltaik und der Displaytechnik eingesetzt. Sie dienen als Kontaktelektroden in Solarzellen, Organischen Leuchtdioden (OLEDs), Touchscreens und Displays. Wichtige Kennzahlen bei der Charakterisierung von TCOs sind eine möglichst hohe optische Transparenz und eine hohe elektrische Leitfähigkeit. Diese Eigenschaften machen TCOs besonders als lichtdurchlässige Elektroden für Solarmodule interessant und bilden zusammen mit der Rückelektrode, Pufferschichten, Antireflexionsschichten und den eigentlichen photoaktiven Halbleitern den Grundaufbau der Solarzelle.

Photovoltaische Schichtsysteme zur direkten Umwandlung von Sonnenstrahlung in elektrische Energie sind bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphen, mikromorphen oder polykristallinem Silizium, Cadmium-Tellurid (CdTe), Gallium-Arsenid (GaAs) oder Kupfer-Indium(Gallium)-Schwefel/Selen (CI(G)S) besonders für Solarzellen geeignet.

Bekannte Trägersubstrate für Dünnschichtsolarzellen enthalten anorganisches Glas, Polymere oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Integration können großflächige Anordnungen von Dünnschichtsolarzellen kostengünstig hergestellt werden.

Dünnschichtsolarzellen zeigen allerdings im Vergleich zu Solarzellen mit kristallinem oder multikristallinem Silizium eine geringere Strahlungsausbeute und einen geringeren elektrischen Wirkungsgrad. Dünnschichtsolarzellen basierend auf Cu(In, Ga)(S, Se)₂ zeigen elektrische Wirkungsgrade, die annährend mit multikristallinen Silizium-Solarzellen vergleichbar sind. CI(G)S-Dünnschichtsolarzellen benötigen eine Pufferschicht zwischen typisch p-leitendem CI(G)S-Absorber und typisch n-leitender Frontelektrode, die üblicherweise Zinkoxid (ZnO) umfasst. Die Pufferschicht kann eine elektronische Anpassung zwischen Absorbermaterial und Frontelektrode bewirken. Die Pufferschicht enthält beispielsweise eine Cadmium-Schwefel-Verbindung. Eine Rückelektrode mit beispielsweise Molybdän wird direkt auf Trägersubstraten abgeschieden.

Eine elektrische Schaltung von mehreren Solarzellen wird als Photovoltaik- oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmodule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Die Erzeugung von optisch transparenten, elektrisch leitfähigen Beschichtungen wie beispielsweise transparenten leitfähigen Oxiden (TCO, transparent conductive oxides) erfordert in der Regel ein Abscheiden, beispielsweise Sputtern, bei hohen Temperaturen. Gleichzeitig bedingen die hohen Temperaturen jedoch aufwendig beheizte Sputteranlagen und eine teure Prozessführung. Eine mögliche Lösung für dieses Problem ist eine Abscheidung bei Raumtemperatur und anschließendes Heizen bei höheren Temperaturen.

Das Heizen bei erhöhten Temperaturen bewirkt jedoch in einer sauerstoffhaltigen Atmosphäre eine zusätzliche Oxidierung der oberen TCO - Schichten. Diese Oxidierung senkt gleichzeitig die elektrische Leitfähigkeit der transparenten leitfähigen Oxide. Zur Verminderung der Oxidierung kann eine zusätzliche inerte Schicht, beispielsweise Si₃N₄ aufgetragen werden. Vor einer weiteren Strukturierung der TCO - Oberfläche muss diese inerte Schicht wieder abgetragen werden. Diese Abtragung der inerten Schicht macht weitere, recht aufwendige Verfahrensschritte notwendig. Zudem kann durch die Abtragung der inerten Schicht auch die TCO - Schicht beschädigt werden.

EP 1 056 136 B1 offenbart ein Substrat für eine Solarzelle, das mindestens eine GlasPlatte, einen ersten und zweiten Grundbeschichtungsfilm und einen leitfähigen Film umfasst. Der erste Grundbeschichtungsfilm enthält mindestens eine der Komponenten Zinnoxid, Titanoxid, Indiumoxid oder Zinkoxid.

US2008/0314442 Al offenbart ein transparentes Substrat mit einer aus mindestens zwei Schichten bestehenden, optisch transparenten Elektrode. Die erste transparente, elektrisch leitfähige Schicht enthält ein nicht dotiertes Mineraloxid, wie beispielsweise Zinnoxid. Die zweite transparente, elektrisch leitfähige Schicht enthält im Gegensatz dazu ein dotiertes Mineraloxid.

US 2009/0084439 Al offenbart eine Solarzelle mit TCO - Schichten. Die Solarzelle enthält einen Aufbau aus einem Substrat, Pufferschicht, einer ersten TCO-Schicht, mehreren Silizium-Schichten, einer zweiten TCO ― Schicht und einer Antireflektionsschicht.

DE 10 2007 024 986 Al offenbart eine temperaturstabile TCO - Schicht und ein Verfahren zu deren Herstellung. Die TCO - Schicht wird mit einer transparenten und leitfähigen Schutzschicht versehen, welche höhere Prozessbedingungen erlaubt. Die Schutzschicht enthält bevorzugt amorphes und im späteren Prozessverlauf kristallines Silizium.

US 2007/0029186 Al offenbart ein Verfahren zur Herstellung eines beschichteten Glassubstrats. Das Verfahren umfasst das Abscheiden eines TCO - Films bei Raumtemperatur auf einem Glassubstrats und die Abscheidung einer Schutzschicht auf dem TCO - Film. Das beschichtete Glassubstrat wird anschließend geheizt.

Die Aufgabe der Erfindung liegt darin, ein Verfahren zur Herstellung eines TCO beschichteten Substrats bereitzustellen, das eine definierte TCO - Abscheidung bei niedrigen Temperaturen und anschließende TCO- Oberflächenstrukturierung ohne wesentliche Abnahme der elektrischen Leitfähigkeit erlaubt.

Die Aufgabe der vorliegenden Erfindung wird erfindungsgemäß durch ein Verfahren zur Herstellung eines beschichteten und reflexionsverminderten Substrats nach dem unabhängigen Anspruch 1 gelöst. Bevorzugte Ausführungen gehen aus den Unteransprüchen hervor.

Die Aufgabe der Erfindung wird weiter durch ein beschichtetes Substrat und dessen Verwendung gemäß weiteren nebengeordneten Ansprüchen gelöst.

Das erfindungsgemäße Verfahren zur Herstellung eines beschichteten Substrats umfasst in einem ersten Schritt das Abscheiden einer TCO - Schicht in einer Schichtdicke von 100 nm bis 1000 nm auf einem Glassubstrat. Die TCO - Schicht wird bevorzugt durch CVD (chemical vapor deposition / Chemische Gasphasenabscheidung), CLD (chemical liquid deposition / Chemische Flüssigphasenabscheidung) und/oder PVD (physical vapor deposition) auf dem Glassubstrat aufgebracht. Die TCO - Schicht wird besonders bevorzugt durch Sputtering und/oder Magnetronsputtering auf dem Glassubstrat aufgebracht. Das Auftragen erfolgt bevorzugt bei Raumtemperatur und das Glassubstrat wird bevorzugt außer durch den Beschichtungsvorgang nicht weiter erwärmt. In einem zweiten Schritt erfolgt das Abscheiden einer inerten Deckschicht mit einer mittleren Schichtdicke von 0,5 nm bis 5 nm. Das Abscheiden erfolgt wie oben beschrieben bevorzugt durch Sputtering, dabei bildet sich die inerte Deckschicht ausgehend von über die Oberfläche verteilten Kristallisationszentren. Diese Kristallisationszentren bilden sich aus lokalen Anhäufungen (Cluster) der inerten Deckschicht. Ausgehend von diesen lokalen Anhäufungen wächst die inerte Deckschicht auf der TCO - Schicht. Da die inerte Deckschicht nur bis zu einer mittleren Schichtdicke von 0,5 nm bis 5 nm aufgetragen wird, ist die inerte Deckschicht nicht homogen über die gesamte TCO-Schicht verteilt, sondern bildet Bereiche mit einer Schichtdicke von 0,5 nm bis 5 nm und Bereiche außerhalb der Cluster, die keine oder weniger als 0,5 nm inerte Deckschicht aufweisen. Im folgenden Schritt wird das beschichtete Substrat bei 550 °C bis 800 °C geheizt und/oder getempert sowie anschließend in einer Säure geätzt. Das Ätzen erfolgt durch Aufsprühen und/oder Eintauchen, das Substrat wird bevorzugt vollständig in die Säure eingetaucht. Die inerte Deckschicht wird vor dem Ätzen nicht entfernt oder abgetragen.

Das Heizen und/oder Tempern erfolgt bevorzugt für 30 s bis 240 s. Der Ausdruck Tempern beschreibt im Sinne der Erfindung ein Heizen bzw. Halten bei konstanter Temperatur.

Das Heizen erfolgt bevorzugt in einer sauerstoffhaltigen Atmosphäre mit mindestens 10 Vol. % O₂, bevorzugt mindestens 15 Vol. % O₂.

Das Abscheiden der TCO Schicht und/oder der inerten Deckschicht erfolgt bevorzugt mittels PVD (physical vapor deposition) und CVD (chemical vapor deposition), besonders bevorzugt mittels Sputtern und insbesondere bevorzugt mittels Kathodenzerstäubung und Magnetronsputtern. Das Abscheiden erfolgt bevorzugt bei Raumtemperatur.

Die inerte Deckschicht wird bevorzugt in einer Schichtdicke von 1 nm bis 4 nm abgeschieden.

Das Ätzen erfolgt bevorzugt mit einer anorganischen und/oder organischen Säure, besonders bevorzugt HF, H₂SiF₆, (SiO₂)ₘ*nH₂O, HCl, H₂SO₄, H₃PO₄, HNO₃, CF₃COOH, CC1₃COOH, HCOOH, CH₃COOH und/oder Gemische davon.

Die Erfindung umfasst des Weiteren ein beschichtetes Substrat. Das beschichtete Substrat enthält bevorzugt Glas oder Polymer. Auf dem Substrat ist eine TCO -Schicht mit einer Schichtdicke von 100 nm bis 1000 nm aufgebracht. Zwischen dem Glassubstrat und der TCO-Schicht ist bevorzugt eine Diffusionssperrschicht aus Si₃N₄, SiO₂ und/oder Al₂O₃ mit einer Dicke von 30 nm bis 100 nm aufgebracht. Die TCO-Schicht ist auf der dem Substrat abgewandten Seite mit einer inerten Deckschicht mit einer mittleren Schichtdicke von 0,5 nm bis 5 nm versehen. Die inerte Deckschicht bedeckt bevorzugt 20 % bis 80 % der Oberfläche der TCO-Schicht. Im Sinne der Erfindung bezieht sich der Ausdruck "bedeckt" auf Bereiche der inerten Deckschicht mit Schichtdicken von ≥ 0,5 nm. Die inerte Deckschicht schützt sowohl die TCO-Schicht während der Herstellung vor Oxidation und wirkt, durch die Abfolge von Bereichen mit inerter Deckschicht und Bereiche ohne inerte Deckschicht auf der Oberfläche der TCO - Schicht, gleichzeitig als Antireflektionsschicht.

Die TCO-Schicht enthält bevorzugt Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), Aluminium, Zink, Indium, Gallium, Silber, Gold, Zinn, Wolfram, Kupfer, Cadmium, Niob, Strontium, Silizium, Zink, Selen und/oder Gemische oder Legierungen davon.

Die inerte Deckschicht weist bevorzugt eine mittlere Schichtdicke von 2 nm bis 4 nm auf.

Die inerte Deckschicht enthält bevorzugt Silizium, Kohlenstoff, Germanium, Si₃N₄ und/oder Gemische davon.

Das Substrat enthält bevorzugt Polymere oder Glas, bevorzugt Flachglas (Floatglas), Quarzglas, Borosilikatglas, Kalk-Natron-Glas und/oder Verbundkörper davon.

Die TCO-Schicht weist bevorzugt einen Flächenwiderstand von < 20 Ω/, bevorzugt < 15 Ω/, besonders bevorzugt < 10 Ω/ auf.

Die Erfindung umfasst des Weiteren die Verwendung des beschichteten Substrats in Solarzellen und/oder Displays, bevorzugt Dünnschichtsolarzellen als Kontaktelektroden mit hoher optischer Transparenz und elektrischer Leitfähigkeit.

Im Folgenden wird die Erfindung anhand einer Zeichnung sowie eines Beispiels und Vergleichsbeispiels näher erläutert. Die Zeichnung ist rein schematisch und nicht maßstabsgetreu. Die Zeichnung schränkt die Erfindung in keiner Weise ein.

Es zeigen:
Figur 1 einen Querschnitt eines beschichteten Substrats nach dem Stand der Technik
und
Figur 2 einen Querschnitt eines erfindungsgemäßen Substrats.

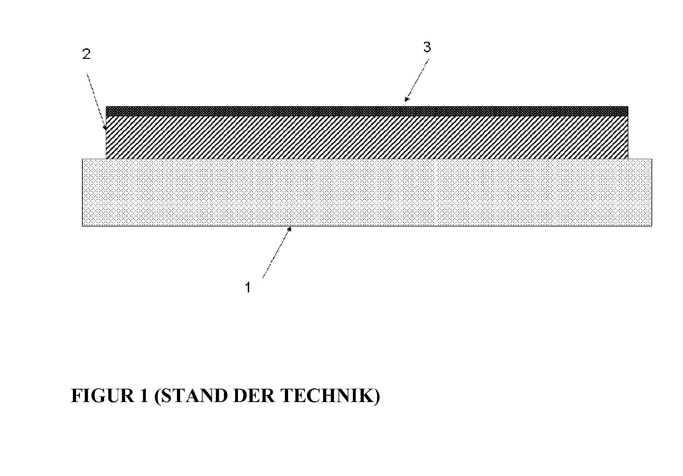

Figur 1 zeigt einen Querschnitt des beschichteten Substrats nach dem Stand der Technik. Auf einem Substrat (1) aus Glas oder Polymer befindet sich eine TCO - Schicht (2). Die TCO - Schicht (2) ist von einer geschlossenen inerten Deckschicht (3) bedeckt.

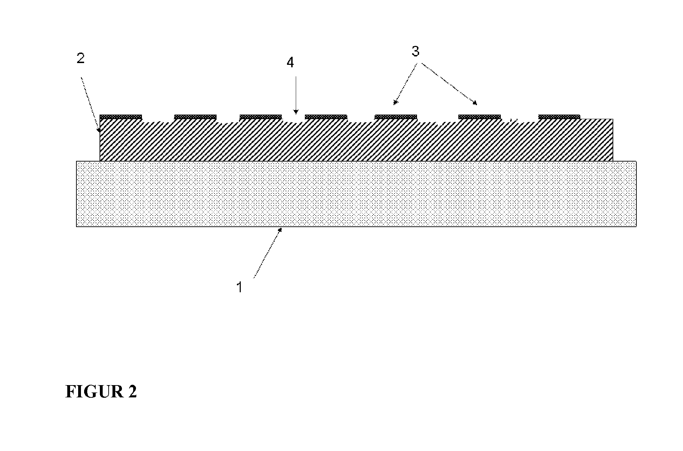

Figur 2 zeigt einen Querschnitt des erfindungsgemäßen Substrats. Auf einem Substrat (1) aus Glas oder Polymer befindet sich eine TCO - Schicht (2). Die TCO - Schicht (2) ist von einer nicht geschlossenen inerten Deckschicht (3) bedeckt. Die Bereiche ohne oder nur mit geringer Schichtdicke der inerten Deckschicht (4) sind für Ätzvorgänge mit Säure oder Base zugänglich und wirken zusammen mit der inerten Deckschicht (3) als Antireflexionsschicht.

Im Folgenden wird die Erfindung anhand eines Beispiels und eines Vergleichsbeispiels näher erläutert.

Es wurde ein erfindungsgemäßes beschichtetes Glassubstrat (A) und ein Glassubstrat (B) nach dem Stand der Technik hergestellt. Die Abscheidung erfolgte durch Sputtern wie beispielsweise in der US2007/0029186 Al beschrieben. Das erfindungsgemäße beschichtete Glassubstrat (A) wies den folgenden Schichtaufbau auf: Glas (3 mm/(1)/Si₃N₄ (50 nm/Diffusionssperrschicht)/ Aluminium-dotiertes Zinkoxid (1000 nm)(2)/Si₃N₄ (2 nm)(3). Das Glassubstrat (B) nach dem Stand der Technik wies den folgenden Schichtaufbau auf: Glas (3 mm)(1)/Si₃N₄ (50 nm)/ Aluminium-dotiertes Zinkoxid (1000 nm)(2). Beide Glassubstrate (A) und (B) wurden in Luft für 75 s bei 650 °C geheizt. Die abgekühlten Glassubstrate (A) und (B) wurden anschließend für 75 s in 0,5 Gew. % HCl getaucht und mit destilliertem Wasser abgespült. Bei beiden Glassubstraten (A) und (B) wurde der Schichtwiderstand R_{V} vor und R_{N} nach dem Heizen und der Säurebehandlung gemessen, sowie die Absorption und die Trübung (Haze) nach der Säurebehandlung bestimmt. Die Ergebnisse sind in Tabelle 1 dargestellt.

**Tabelle 1: Schichtwiderstand R_{V} vor und R_{N} nach dem Heizen, Absorption und Trübung (Haze) des erfindungsgemäßen Glassubstrat (A) und dem Glassubstrat (B) nach dem Stand der Technik.**

| | R_{□V} [Ω/□] | R_{□N} [Ω/□] | Absorption [%] | Trübung (Haze) [%] |
|---|---|---|---|---|
| Glassubstrat (A) | 14 | 6 | 4.3 | 21 |
| Glassubstrat (B) | 14 | 12 | 4.6 | 22 |

Aus Tabelle 1 ist ersichtlich, dass der Schichtwiderstand R_{N} nach Heizen und der Behandlung mit Säure beim erfindungsgemäßen Glassubstrat (A) mit 57 % im Vergleich zum Glassubstrat (B) nach dem Stand der Technik mit 14 % deutlich abnimmt. Die Werte der Absorption und der Trübung bleiben im Wesentlichen konstant, so dass diese Eigenschaften der TCO - Beschichtung auch durch die dünnere erfindungsgemäße inerte Deckschicht nicht schlechter werden. Vielmehr erlaubt das erfindungsgemäße Verfahren zur Herstellung eines beschichteten Glassubstrats eine deutliche Verringerung des Schichtwiderstandes. Diese Ergebnisse waren überraschend und nicht naheliegend.

Es zeigen:
- 1: Substrat
- 2: TCO-Schicht
- 3: inerte Deckschicht und
- 4: Bereiche ohne inerte Deckschicht.

## Patentansprüche

1. Verfahren zur Herstellung eines beschichteten Substrats, wobei
a. eine TCO-Schicht (2) mit einer Schichtdicke von 100 nm bis 1000 nm auf einem Substrat (1) abgeschieden wird,
b. eine inerte Deckschicht (3) mit einer mittleren Schichtdicke von 0,5 nm bis 5 nm auf der TCO-Schicht (2) abgeschieden wird und
c. das Substrat (1) bei 550 °C bis 800 °C geheizt und anschließend in einer Säure geätzt wird, wobei die inerte Deckschicht vor dem Ätzen nicht entfernt wird.

2. Verfahren nach Anspruch 1, wobei das Substrat (1) in einer sauerstoffhaltigen Atmosphäre mit mindestens 10 Vol. % O₂, bevorzugt mindestens 15 Vol. % O₂ geheizt wird.

3. Verfahren nach Anspruch 1 oder 2, wobei die TCO-Schicht (2) und/oder die inerte Deckschicht (3) mittels PVD und CVD, bevorzugt mittels Sputtern, besonders bevorzugt mittels Kathodenzerstäubung und Magnetronsputtern abgeschieden wird.

4. Verfahren nach einem der Ansprüche 1 bis 3, wobei die TCO-Schicht (2) und/oder die inerte Deckschicht (3) bei Raumtemperatur abgeschieden wird.

5. Verfahren nach einem der Ansprüche 1 bis 4, wobei die inerte Deckschicht (3) mit einer Schichtdicke von 1 nm bis 4 nm abgeschieden wird.

6. Verfahren nach einem der Ansprüche 1 bis 5, wobei das Ätzen mit einer anorganischen und/oder organischen Säure, bevorzugt HF, H₂SiF₆, (SiO₂)ₘ*nH₂O, HCl, H₂SO₄, H₃PO₄, HNO₃, CF₃COOH, CCl₃COOH, HCOOH und/oder CH₃COOH erfolgt.

7. Beschichtetes Substrat, mindestens umfassend:
a. ein Substrat (1),
b. eine TCO -Schicht (2) mit einer Schichtdicke von 100 nm bis 1000 nm auf dem Glassubstrat (1) und
c. eine inerte Deckschicht (3) in einer mittleren Schichtdicke von 0,5 nm bis 5 nm auf der TCO-Schicht (2).

8. Beschichtetes Substrat nach Anspruch 7, wobei die TCO-Schicht (2) Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), Aluminium, Zink, Indium, Gallium, Silber, Gold, Zinn, Wolfram, Kupfer, Antimon, Cadmium, Niob, Strontium, Silizium, Zink, Selen und/oder Gemische oder Legierungen davon enthält.

9. Beschichtetes Substrat nach einem der Ansprüche 7 oder 8, wobei die inerte Deckschicht (3) eine mittlere Schichtdicke von 1 nm bis 4 nm aufweist.

10. Beschichtetes Substrat nach einem der Ansprüche 7 bis 9, wobei die inerte Deckschicht (3) 20 % bis 80 % der Oberfläche der TCO-Schicht (2) bedeckt.

11. Beschichtetes Substrat nach einem der Ansprüche 7 bis 10, wobei die inerte Deckschicht (3) Si, C, Al, Ge, Al₂O₃, SiO₂, Ge, Si₃N₄ und/oder Gemische davon enthält.

12. Beschichtetes Substrat nach einem der Ansprüche 7 bis 11, wobei das Substrat (1) Polymere oder Glas, bevorzugt Flachglas (Floatglas), Quarzglas, Borosilikatglas, Kalk-Natron-Glas und/oder Verbundkörper davon enthält.

13. Beschichtetes Substrat nach einem der Ansprüche 7 bis 12, wobei die TCO-Schicht (2) einen Flächenwiderstand von < 20 Ω/, bevorzugt < 15 Ω/ und besonders bevorzugt < 10 Ω/ aufweist.

14. Verwendung des beschichteten Substrats nach einem der Ansprüche 7 bis 13 in Solarzellen, elektrochromen Verglasungen und/oder Displays, bevorzugt in Dünnschichtsolarzellen.
